# EUROPÄISCHE PATENTANMELDUNG

(11) **EP 0 608 478 A2**
(43) Veröffentlichungstag der Anmeldung: **03.08.1994**
(21) Anmeldenummer: 93114244.2
(22) Anmeldetag: 06.09.1993
(51) Int. Cl.: C23C 14/34

(54) **Vorrichtung zur Kathodenzerstäubung**

(30) Priorität: 28.01.1993 DE 9217937
(71) Anmelder: LEYBOLD AKTIENGESELLSCHAFT, D-63450 Hanau (DE)
(72) Erfinder: Sichmann, Eggo, D-63517 Gelnhausen (DE)

(57) **Zusammenfassung**

Vorrichtung zur Kathodenzerstäubung für die Herstellung dünner Schichten auf einem Substrat (13) mittels eines Plasmas in einer Vakuumprozeßkammer (11), im wesentlichen bestehend aus Magneten, Polschuhen, einer Anode, einem als Kathode ausgebildeten Target aus dem zu zerstäubenden Werkstoff und einer Blendenanordnung, wobei
a) die dem Substrat (13) zugewandte, zu zerstäubende Vorderseite des Targets (16) im wesentlichen dachförmig verläuft und die Dachflächen symmetrisch zur Achse A-A des Targets ausgeführt sind, daß die Dachform durch mindestens zwei oder mehr Ebenen gebildet wird und die Senkrechten, die auf den Vorderseiten der beiden längsten Ebenen erzeugbar sind, ihren gemeinsamen Schnittpunkt vor dem Target (16) haben,
b) nur ein Magnetsatz (2) mit Polschuhen (1a,4) verwendet wird,
c) die dem Substrat(13) zugewandten Stirnseiten (1b,4a) der Polschuhe (1a,4) mit einer Schräge versehen sind.

## Beschreibung

Die Erfindung beschreibt eine Vorrichtung zur Kathodenzerstäubung für die Herstellung dünner Schichten auf einem Substrat mittels eines Plasmas in einer Vakuumprozeßkammer, im wesentlichen bestehend aus Magneten, Polschuhen, einer Anode, einem als Kathode ausgebildeten Target aus dem zu zerstäubenden Werkstoff und einer Blendenanordnung.

Zur Herstellung dünner Schichten auf einem Substrat, vorzugsweise zur Beschichtung von Compact Discs, sind zum Stand der Technik vielfältige Lösungen bekannt.

So beschreibt beispielsweise die EP 0 163 445 einen Targetsatz für eine Vorrichtung zum Sputtern im Vakuum mit einem ersten und zweiten Kathodenelement aus Sputtermaterial, wobei das zweite das erste umgibt, die Geometrien des ersten und zweiten Elementes so sind, daß, wenn sie sich im Vakuum befinden, Material von der emittierenden Oberfläche des zweiten Elementes, welche Oberfläche außerhalb derjenigen des ersten Elementes liegt, gesputtert werden kann und daß das erste Targetelement eine ringförmige Kathode ist und die anfängliche emittierende Oberfläche des zweiten Elementes kelgelstumpfförmig ist.

Eine weitere Schrift US 4,747,926 beansprucht ebenfalls ein kegelstumpfförmiges Sputter-Target zum Einsatz in einer Magnetron-Sputter-Vorrichtung, im wesentlichen bestehend aus einem einstückigen Target mit zwei Oberflächenbereichen, die parallel zum zentralen Bereich eines planaren Substrates verlaufen und einem dritten geneigten Bereich, der den ersten und zweiten Bereich verbindet, einer Tragplatte sowie Mittel zur Erzeugung eine Magnetfeldes, für die Erzeugung von zwei Plasmen verschiedenen Durchmessers.

Als weitere Schrift sei die US 4,933,064 genannt. Diese beansprucht eine Sputter Kathode nach dem Magnetron-Prinzip mit einem Target mit wenigstens zwei durchgehenden, konzentrischen Vorsprüngen, deren Wandflächen senkrecht zur Sputterfläche verlaufen, ein Permanent-Magnet-System mit weichmagnetischen Polschuhen, von deren Polflächen aus Magnetfeldlinien die Sputterfläche kreuzen.

Diese oben genannten und weitere bekannte Erfindungen haben alle den Nachteil, daß sie erstens eine relativ hohe elektrische Anschlußleistung für die Sputterstromversorgung benötigen, daß sie zweitens einen nur unbefriedigenden Wirkungsgrad beim Sputtern erreichen, d.h. daß zuviel Targetwerkstoff auf Abschirmungen und Blenden niedergeschlagen wird, anstatt auf dem Substrat, daß drittens der mechanische Aufbau der Kathode zu aufwendig ist und daß viertens die Störanfälligkeit der Sputter-Stromversorgung-SSV, bedingt durch Arcs zu groß ist und es damit zu häufigen Abschaltungen der SSV kommt.

Der Erfindung liegt daher die Aufgabe zugrunde, alle die obengenannten Nachteile zu minimieren, beziehungsweise abzustellen und die Vorrichtung somit betriebssicherer, zuverlässiger und preiswerter in der Herstellung sowie im Betrieb zu machen. Diese Aufgabe wird erfindungsgemäß gelöst, indem
a) die dem Substrat zugewandte, zu zerstäubende Vorderseite des Targets im wesentlichen dachförmig verläuft und die Dachflächen symmetrisch zur Achse A-A des Targets ausgeführt sind, daß die Dachform durch mindestens zwei oder mehr Ebenen gebildet wird und die Senkrechten, die auf den Vorderseiten der beiden längsten Ebenen erzeugbar sind, ihren gemeinsamen Schnittpunkt vor dem Target haben,
b) nur ein Magnetsatz mit Polschuhen verwendet wird,
c) die dem Substrat zugewandten Stirnseiten der Polschuhe mit einer Schräge versehen sind.

Die hier beschriebene Erfindung erfüllt mit Vorteil alle an sie gestellten Aufgaben.
So wird durch die gewählte Target-Geometrie eine fokussierende Sputterrichtung erreicht. Dadurch wird der Anteil der Teilchen erhöht, die sich auf dem Substrat niederschlagen, der Teil, der auf die umgebenden Bauteile auftrifft reduziert und der Wirkungsgrad somit meßbar erhöht.

Durch den dachförmigen Knick der Targetoberfläche wird in diesem Knick ein elektrostatischer Einschluß der Elektronen erzielt und damit auch die Zündbedingung für einen ersten Plasmaring erfüllt.

Durch diesen "Knick" kann auf Targetflanken (bekannt durch Zwischen-Pol-Target/ZPT-Kathoden) verzichtet werden. Dadurch wird die gesamte Targetoberfläche als aktiv sputternde Fläche wirksam und es besteht mit Vorteil nicht mehr die Gefahr der partiellen Belegung der Targetoberfläche.

Durch geschickte Ausbildung der, das Target überspannenden Magnetfeldlinien kann zu dem ersten Plasma ein Sekundärplasma erzeugt werden. Dieses bildet sich als Plasmaring konzentrisch zu dem ersten Plasmaring aus und bewirkt eine Verbreiterung des Targeterosionsprofils.

Um die Targetlebensdauer zu erhöhen und die Sputterleistung bei weitgehend erodierten Targets gering zu halten, sollte das sich ausbildende Erosionsprofil möglichst breit in Relation zur Tiefe sein. Aus diesem Grund werden ringförmige Bleche aus nichtmagnetischem Material zwischen Target und Joch unter Einhaltung des Dunkelraumabstandes angebracht. Dadurch werden die senkrecht aus den Polschuhen austretenden Magnetfelder in ihrer Stärke auf die Targetoberfläche vergleichmäßigt, was zur Ausbildung breiter Erosionsgräben führt.

Durch die Abschrägung der Polschuhe überqueren die Magnetfeldlinien mit einem bestimmten Winkel die Targetoberfläche, der meist nicht parallel ist wie z.B. beim ZPT. Durch diese Neigung werden die Elektronen im wesentlichen nur bei neuen (nicht erodierten) Targets durch magnetischen Einfluß nahe der Targetoberfläche gehalten (Fokussierung der Elektronen Richtung Targetmitte).

Mit steigender Targeterosion wird der Sputtervorgang hauptsächlich durch parallele Magnetfeldlinien beeinflußt und es entsteht ein breites Erosionsprofil.
Am Außendurchmesser des Targets bildet sich mit fortschreitender Erosion eine "Targetwand" aus, die den elektrostatischen Einschluß der Elektronen bewirkt.

Ebenfalls vorteilhaft ist bei dieser erfindungsgemäßen Kathode, daß nur ein Magnetsatz gleich ausgerichteter Pole zur Erzeugung des Gesamtmagnetfeldes verwendet wird. Ein virtueller Gegenpol bildet sich in Kathodenmitte automatisch aus, ohne daß es zusätzlicher Magnete bedarf. Die Stärke des Magnetfeldes sowie dessen Struktur läßt sich durch Optimierung, bzw. Anpassen des axialen Abstandes zwischen Polschuh und Magnet variieren. Vorteilhaft ist eine solche Anordnung der Magnete an die Atmosphäre; dadurch werden Überschläge zwischen Kathodenpotential (Target) und Jochpotential reduziert, da die Magnete im Vakuum nahe des Kathodenpotentials durch viele Streumagnetfelder und Hohlräume eine häufige Überschlagsquelle sind.

In dem Ausführungsbeispiel besteht die Anode, beziehungsweise die auf Anodenpotential geschalteten Bauteile, im wesentlichen aus dem eigentlichen Anodenring und einem Abschirmring. Die Anode ist als Teil der Prozeßkammer elektrisch isoliert und wird auch nur durch einen an der Atmosphärenseite angeordneten Kühlkanal gekühlt, so daß für die Anodenkühlung mit Vorteil kein Kühlmittelkreislauf innerhalb der Vakuumkammer erforderlich ist.

Weiterhin sind der Anoden- und der Abschirmring mit Vorteil so ausgestaltet, daß während des Zerstäubungsvorgangs nur der Abschirmring beschichtet werden kann und der Anodenring unbeeinflußt bleibt. Der Abschirmring ist austauschbar.

Die notwendige elektrische Anschlußleistung der Sputterstromversorgung konnte entscheidend reduziert werden. In einer Versuchsanlage die bislang ca. 30 kW benötigte, kommt man mit der erfindungsgemäßen Kathodenanordnung nun mit der halben Leistung von ca. 15 kW aus.

Die meistverwendeten Targetwerkstoffe, insbesondere bei der Beschichtung kleiner Substrate, wie beispielsweise CD's, sind Al und AlCu-Legierungen. Mit der hier beschriebenen Erfindung ist auch eine Anwendung zum reaktiven Sputtern unterschiedlichster Targetwerkstoffe denkbar.

Weitere Ausführungsmöglichkeiten und Merkmale sind in den Unteransprüchen näher beschrieben und gekennzeichnet.

Die Erfindung läßt die verschiedensten Ausführungsmöglichkeiten zu; ein Beispiel ist in den anhängenden Zeichnungen näher dargestellt und zwar zeigen:
- Fig. 1:: Einen Teilschnitt durch eine rotationssymmetrische, erfindungsgemäße Kathodenanordnung zur Beschichtung insbesondere kleiner, kreisscheibenförmiger Substrate und
- Fig. 2:: eine stark vereinfachte Darstellung einer Kathodenanordnung gem. Fig. 1 mit Magnetfeldlinienverlauf.

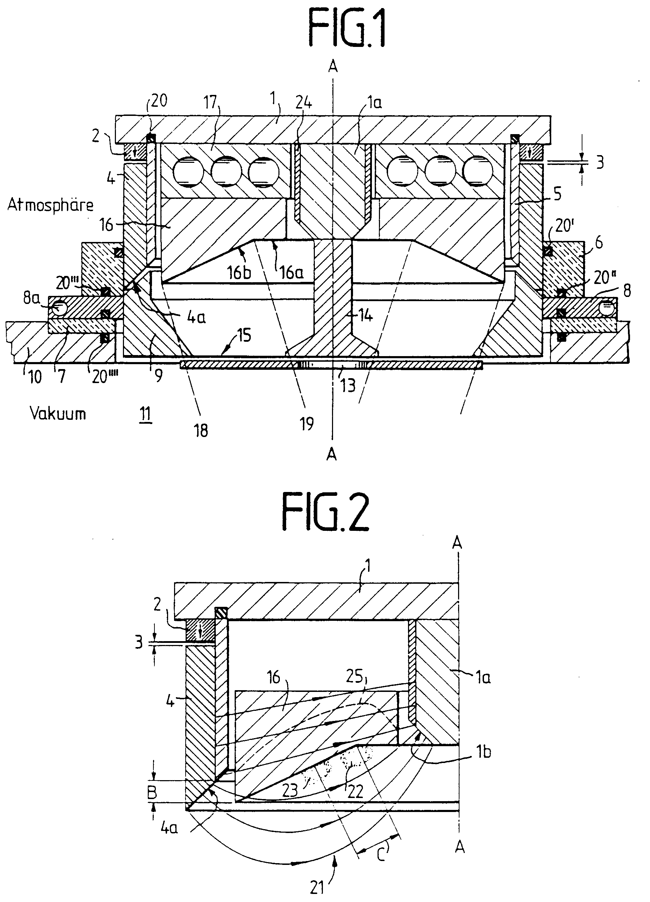

Ein im wesentlichen kreisscheibenförmiges Joch 1 (Fig.1) mit einem in Richtung der Rotationsachse A-A angeordnetem zentralen Polschuh 1a ist auf seiner Innenseite mit einem Ringmagnet 2 versehen. Über einen definierten axialen Abstand 3 schließt sich der Magnet 2, ein im wesentlichen hohlzylindrischer Polschuh 4, mit einer angeschrägten Stirnseite 4a an, wobei die Schräge zur Achse A-A hin zeigt. Der Polschuh 4 stützt sich gegen einen radial innen liegenden Blechring 5 aus nichtmagnetischem Werkstoff.

Zwischen zwei Isolationsringen 6,7 befindet sich eine ringförmige, mit einem Kühlkanal 8a versehene, Anode 8, an die sich in radialer Richtung ein Abschirmring 9 anschließt. In axialer Richtung ist die Anode 8 mit der Kammerwand 10, einer Vakuum-Prozeßkammer 11, verbunden. Für die Abdeckung des Innenrandes des Substrats 13 ist eine Mittelmaske 14 vorgesehen, die mit dem zentralen Polschuh 1a verbunden ist.

Durch den als Blende ausgebildeten Abschirmring 9 und die Mittelmaske 14 wird eine ringförmige Öffnung 15 gebildet, von der das zu beschichtende, kreisscheibenfömige Substrat 13 positioniert ist.

Das zu zerstäubende Target 16 ist konzentrisch zur Achse A-A vorgesehen und über eine kühlbare Grundplatte 17 mit dem Joch 1 verbunden. Das Target 16 weist auf seiner zum Substrat 13 hin zugehenden Oberfläche eine Knick auf; dieser wird gebildet durch einen radial innenliegenden, ringförmigen Bereich 16a, der parallel zur Substratoberfläche verläuft und einen sich diesem Bereich direkt anschließenden radial außen liegenden Bereich 16b mit einer nach innen geneigten Oberfläche.

Dadurch wird der von diesem Bereich 16b abgestäubte Targetwerkstoff zum Substrat 13 hin fokussiert. Die Hauptzerstäubungsrichtung wird durch die beiden Linien 18, 19 markiert, die im wesentlichen lotrecht auf der Oberfläche des äußeren Bereichs 16b stehen und zur Achse A-A hin zeigen.

Die Bauteile 4,5,6,7 und 8, die das Target 16 in radialer Richtung umgeben, sind jeweils mit einem Dichtring 20, 20',... vakuumdicht miteinander verbunden und bilden zusammen mit der Kammerwand 10 und dem Joch 1 einen das Target 16 umschließenden Vakuumraum. Dadurch wird ermöglicht, daß der Ringmagnet 2 an Atmosphäre angeordnet und die Kühlung der Anode 8 von der Atmosphärenseite her erfolgt.

In der Fig. 2 sind nochmals einige der in Fig. 1 bereits gezeigten Komponenten auszugsweise dargestellt, die zur Erläuterung des Wirkprinzips der erfindungsgemäßen Kathodenanordnung hilfreich sind.
Das Joch 1 und der Polschuh 1a sind aus ferromagnetischem Werkstoff hergestellt. Ein einziger Ringmagnet 2 dient zur Erzeugung des Gesamtmagnetfeldes 21, wobei sich der Polschuh 1a automatisch als virtueller Gegenpol ausbildet, ohne daß es zusätzlicher Magnete bedarf. Die Magnetfeldlinien 21 treten zum einen aus der Stirnseite 4a des Polschuhs 4 aus und verlaufen bogenförmig vor dem Target 16 bis zur Stirnseite 1b des Polschuhs 1a. Zum anderen tritt ein Teil der Magnetfeldlinien 21 seitlich aus dem Polschuh 4 aus, durchdringt das Target 16 annähernd geradlinig und tritt wieder seitlich in den Polschuh 1a ein.

Durch die Abschrägung der Stirnseiten 1b und 4a der Polschuhe 1a und 4 verlaufen die Feldlinien 21 unter einem definierten Winkel zur Targetoberfläche. Dieser Verlauf bedingt den elektrostatischen Einschluß von Elektronen nahe der Targetoberfläche der notwendig ist, um Zündbedingungen für den Kathodenzerstäubungsvorgang zu erreichen. Diese Bedingung ist zuerst in dem Knick zwischen dem inneren -16a und dem schrägen äußeren Bereich -16b des Targets 16 gegeben, so daß sich hier zunächst ein erster Plasmaschlauch 22 ausbildet.

Bei der skizzierten Ausbildung des Magnetfeldes 21 liegt der Nulldurchgang der Magnetfeldlinien 21 in etwa in der radial innenliegenden ersten Hälfte des angeschrägten Bereichs 16b der Targetoberfläche, so daß sich hier ein zweiter Plasmaschlauch 23 ausbildet.

Die Stärke, sowie die Struktur des Magnetfeldes 21 ist durch Variation des Abstandes 3 zwischen Magnet 2 und Polschuh 4 anpassungsfähig.

### Bezugszeichenliste

- 1: Joch
- 1a: Polschuh
- 1b: Stirnseite
- 2: Ringmagnet, Magnetsatz
- 3: Abstand
- 4: Polschuh
- 4a: Stirnseite
- 5: Ring
- 6: Isolationsring
- 7: Isolationsring
- 8: Anode
- 8a: Kühlkanal
- 9: Abschirmring
- 10: Kammerwand
- 11: Vakuum-Prozeßkammer
- 13: Substrat
- 14: Mittelmaske
- 15: Öffnung
- 16: Target
- 16a: Bereich, Fläche innen
- 16b: Bereich, Fläche außen
- 17: Grundplatte
- 18: Linie
- 19: Linie
- 20,20',...: Dichtring
- 21: Magnetfeld, -linien
- 22: Plasmaschlauch
- 23: Plasmaschlauch
- 24: Ring
- 25: Sputtergraben
- A-A: Rotationsachse
- B: Abstand
- C: Abstand

## Patentansprüche

1. Vorrichtung zur Kathodenzerstäubung für die Herstellung dünner Schichten auf einem Substrat (13) mittels eines Plasmas (22) in einer Vakuumprozeßkammer (11), im wesentlichen bestehend aus Magneten, Polschuhen, einer Anode, einem als Kathode ausgebildeten Target aus dem zu zerstäubenden Werkstoff und einer Blendenanordnung, **dadurch gekennzeichnet**, daß
a) die dem Substrat (13) zugewandte, zu zerstäubende Vorderseite des Targets (16) im wesentlichen dachförmig verläuft und die Dachflächen symmetrisch zur Achse A-A des Targets ausgeführt sind, daß die Dachform durch mindestens zwei oder mehr Ebenen gebildet wird und die Senkrechten, die auf den Vorderseiten der beiden längsten Ebenen erzeugbar sind, ihren gemeinsamen Schnittpunkt vor dem Target (16) haben,
b) nur ein Magnetsatz (2) mit Polschuhen (1a,4) verwendet wird,
c) die dem Substrat (13) zugewandten Stirnseiten (1b,4a) der Polschuhe (1a,4) mit einer Schräge versehen sind.

2. Vorrichtung nach Anspruch 1, **dadurch gekennzeichnet**, daß die Kathodenanordnung rotationssymmetrisch zur Achse A-A ist.

3. Vorrichtung nach Anspruch 1, **dadurch gekennzeichnet**, daß der Magnetsatz (2) aus gleichgerichteten Einzelmagneten besteht.

4. Vorrichtung nach Anspruch 1, **dadurch gekennzeichnet**, daß der Magnetsatz (2) das Target (16) radial umschließt und an der Atmosphärenseite der Prozeßkammer (11) angeordnet ist.

5. Vorrichtung nach Anspruch 1, **dadurch gekennzeichnet**, daß zwischen dem Ringmagnet (2) und dem Polschuh (4) ein Abstand (3) in Richtung der Achse A-A vorgesehen ist.

6. Vorrichtung nach Anspruch 5, **dadurch gekennzeichnet**, daß der Abstand (3) einstellbar ist.

7. Vorrichtung nach Anspruch 1, **dadurch gekennzeichnet**, daß die radial äußere Vorderkante eines neuen, unverbrauchten Targets (16) die radial innere Vorderkante des Polschuhes (4) in Richtung auf das Substrat (13) um den Abstand (B) überragt.

8. Vorrichtung nach Anspruch 1, **dadurch gekennzeichnet**, daß zwischen dem zentral angeordneten Target (16) und dem das Target umgebenden Polschuh (4) ein Ring (5) aus nicht magnetischem Werkstoff vorgesehen ist.

9. Vorrichtung nach Anspruch 1, **dadurch gekennzeichnet**, daß zwischen dem zentral angeordneten Polschuh (1a) und dem, den Polschuh (1a) umgebenden Target (16) ein Ring (24) aus nicht magnetischem Werkstoff vorgesehen ist.

10. Vorrichtung nach Anspruch 8 und 9**, dadurch gekenn****zeichnet**, daß die Ringe (5, 24) jeweils im Dunkelraumabstand zum Target (16) angeordnet sind.

11. Vorrichtung nach Anspruch 1, **dadurch gekennzeichnet**, daß die das Target (16) umgebenden Bauteile Joch (1), Ring (5), Polschuh (4), Anode (8), Isolationsringe (6, 7) und die Kammerwand (10) vakuumdicht mit dem jeweils benachbarten Bauteil verbunden sind.

12. Vorrichtung nach Anspruch 11, **dadurch gekennzeichnet**, daß zwischen den Bauteilen nach Anspruch 8 (1,4,5,6,7,8,10) jeweils ein Dichtring (20, 20',...) montiert ist.

13. Vorrichtung nach Anspruch 1, **dadurch gekennzeichnet**, daß die das Target (16) umgebenden Bauteile Joch (1), Ring (5), Polschuh (4), Isolationsringe (6,7), Anode (8) und die Kammerwand (10) kraftschlüssig miteinander verbunden sind.

14. Vorrichtung nach Anspruch 1, **dadurch gekennzeichnet**, daß ein Kühlkanal (8a) in dem radial außen liegenden Bereich der Anode (8) vorgesehen ist.

15. Vorrichtung nach Anspruch 14, **dadurch gekennzeichnet**, daß der radial äußere Bereich der Anode (8) unter Atmosphärendruck liegt und nur dort gekühlt wird.

16. Vorrichtung nach Anspruch 1, **dadurch gekennzeichnet**, daß die Anode (8) mit einem Abschirmring (9) direkt verbunden ist.

17. Vorrichtung nach Anspruch 1, **dadurch gekennzeichnet**, daß die Anode (8) mit dem Abschirmring (9) im Dunkelraumabstand zum Target (16) angeordnet ist.

18. Vorrichtung nach Anspruch 1, **dadurch gekennzeichnet**, daß der Polschuh (4), der Ring (5), der Magnetsatz (2), das Joch (1), der Polschuh (1a) sowie der Ring (24) auf Anodenpotential geschaltet sind.

19. Vorrichtung nach Anspruch 1, **dadurch gekennzeichnet**, daß der Abschirmring (9), sowie die Mittelmaske (14) auf elektrisch floatendem Potential liegen.

20. Vorrichtung nach Anspruch 1, **dadurch gekennzeichnet**, daß das zu beschichtende Substrat (13) flach und kreisscheibenförmig ist.

21. Vorrichtung nach Anspruch 1, **dadurch gekennzeichnet**, daß ein erstes Plasma (22) durch elektrostatischen Einschluß in dem dachförmigen Knick auf der Targetvorderseite erzeugt wird.

22. Vorrichtung nach Anspruch 1, **dadurch gekennzeichnet**, daß die Schräge der Stirnseite (4a) des Polschuhes (4) so ausgebildet ist, daß die von ihr austretenden Magnetfeldlinien (21) die Vorderseite des Targets (16) bogenförmig überspannen und in die Stirnseite (1b) des zentrisch angeordneten Polschuhs (1a) wieder eintreten.

23. Vorrichtung nach Anspruch 1, **dadurch gekennzeichnet**, daß das Magnetfeld (21) so ausgebildet ist, daß die senkrechte Projektion des Magnetfeldes (21) auf die dachförmige Ebene des äußeren Bereichs (16b) des Targets (16) auftrifft.

24. Vorrichtung nach Anspruch 1, **dadurch gekennzeichnet**, daß an der Auftreffstelle nach Anspruch 23 ein zweites Plasma (23) erzeugbar ist.

25. Vorrichtung nach Anspruch 1, **dadurch gekennzeichnet**, daß beide Plasmen ( 22,23) ringförmig sind.

26. Vorrichtung nach Anspruch 1, **dadurch gekennzeichnet**, daß das zweite Plasma (23) in einem Abstand (C) zu dem ersten Plasma (22) erzeugt wird.

27. Vorrichtung nach Anspruch 26, **dadurch gekennzeichnet**, daß der Abstand (C) so bemessen ist, so daß eine Verteilung der Plasmaintensität auf der Targetvordereite mit zwei Maxima erreicht wird.

28. Vorrichtung nach Anspruch 27, **dadurch gekennzeichnet**, daß durch die zwei beabstandeten Plasmen (22,23) ein Sputtergraben (25) mit einem, im Querschnitt, breiten Grabenprofil erzeugt wird.
